**Europäisches Patentamt**

**European Patent Office**

**Office européen des brevets**

(19)

(11) Veröffentlichungsnummer: **0 242 560**
**A1**

(12) # EUROPÄISCHE PATENTANMELDUNG

(21) Anmeldenummer: **87103424.5**

(22) Anmeldetag: **10.03.87**

(51) Int. Cl.⁴: **G01R 15/02** , G01R 33/06

(30) Priorität: **25.04.86 DE 3613976**

(43) Veröffentlichungstag der Anmeldung:
**28.10.87 Patentblatt 87/44**

(84) Benannte Vertragsstaaten:
**DE FR GB IT SE**

(71) Anmelder: **VDO Adolf Schindling AG**
**Gräfstrasse 103**
**D-6000 Frankfurt/Main(DE)**

(72) Erfinder: **Porth, Wolfgang**
**Röhrborngasse 70**
**D-6000 Frankfurt am Main(DE)**
Erfinder: **Weibler, Wolfgang, Dr.**
**Vor der Heide 14**
**D-6238 Hofheim a. T.(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Anordnung zur berührungslosen Messung des elektrischen Stroms in einem Leiter.**

(57) Bei einer Anordnung zur berührungslosen Messung des elektrischen Stroms in einem Leiter (1), bei welcher ein den Leiter umschließender Magnetkern (3) einen Spalt aufweist, in welchem ein Magnetfeldsensor (5) angeordnet ist, entspricht die Polfläche des Magnetkerns im wesentlichen der aktiven Fläche des Magnetfeldsensors. Dabei kann vorzugsweise die Querschnittsfläche des Magnetkerns mit zunehmender Entfernung vom Spalt größer werden.

FIG. 1

## Anordnung zur berührungslosen Messung des elektrischen Stroms in einem Leiter.

Die Erfindung betrifft eine Anordnung zur berührungslosen Messung des elektrischen Stroms in einem Leiter, bei welcher ein den Leiter umschließender Magnetkern einen Spalt aufweist, in welchem ein Magnetfeldsensor angeordnet ist.

Derartige Anordnungen werden zur Strommessung verwendet, wenn beispielsweise eine galvanische Trennung zwischen dem zu messenden Strom und einem Meßstromkreis erfolgen soll oder wenn in den Stromkreis kein Widerstand eingefügt werden soll, welcher den Abfall einer Meßspannung bewirkt. Letzteres ist insbesondere bei elektrischen Anlagen von Kraftfahrzeugen der Fall, wo relativ hohe Ströme bei geringen Spannungen auftreten. Bei den bekannten Anordnungen für diesen Zweck ist jedoch die Querschnittsfläche größer als die aktive Fläche des Magnetfeldsensors. Dadurch gehen magnetische Kraftlinien fur die Auswertung des Kraftfeldes im Magnetfeldsensor verloren, was zu einer geringen Empfindlichkeit derartiger Anordnungen fOhrt.

Aufgabe der vorliegenden Erfindung ist es, eine Anordnung zur berührungslosen Messung des elektrischen Stroms in einem Leiter anzugeben, bei welchem bereits bei geringem Strom eine auswertbare Spannung am Magnetfeldsensor entsteht.

Die erfindungsgemäße Anordnung ist dadurch gekennzeichnet, daß die Polfläche des Magnetkerns im wesentlichen der aktiven Fläche des Magnetfeldsensors entspricht. Dadurch wird gegenüber bekannten Anordnungen eine höhere Meßempfindlichkeit erreicht.

Eine Weiterbildung der Erfindung besteht darin, daß die Querschnittsfläche des Magnetkerns mit zunehmender Entfernung vom Spalt größer wird. Dieses führt zu einer weiteren Steigerung der Meßempfindlichkeit.

Eine andere Weiterbildung besteht darin, daß die den Magnetkern in Längsrichtung des Leiters begrenzenden Kanten in je einer Ebene liegen, welche nicht senkrecht zur Achse des durch den Magnetkern gebildeten Kreisrings liegt. Hierdurch wird einerseits eine allmähliche Steigerung des Querschnitts des Magnetkerns erreicht, was in der Nähe der Pole zu einer Verringerung des Streuflusses führt und andererseits bei der Herstellung derartiger Magnetkerne einen geringen Verschnitt bewirkt.

Gemäß einer weiteren Weiterbildung der Erfindung besteht der Magnetkern aus amorphem metallischem Glas hoher Permeabilität, was einerseits eine geringe Remanenz aufweist und andererseits gut zu bearbei ten ist, da es unter anderem als Folie erhältlich ist.

Ein vorteilhaftes Verfahren zur Herstellung einer erfindungsgemäßen Anordnung besteht darin, daß durch ein Rohr aus weichmagnetischem Werkstoff Schnitte gelegt werden, welche in Ebenen liegen, die abwechselnd in zwei verschiedenen Richtungen Winkel mit der zur Rohrachse senkrechten Ebene bilden, und daß die somit entstehenden Rohrabschnitte an ihrer engsten Stelle geschlitzt werden.

Die Erfindung läßt zahlreiche Ausführungsformen zu. Zwei davon sind schematisch in der Zeichnung an Hand mehrerer Figuren dargestellt und nachfolgend beschrieben. Es zeigt:

Fig. 1 ein erstes Ausführungsbeispiel in zwei Ansichten und

Fig. 2 ein zweites Ausführungsbeispiel, ebenfalls in zwei Ansichten.

Gleiche Teile sind in den Figuren mit gleichen Bezugszeichen versehen.

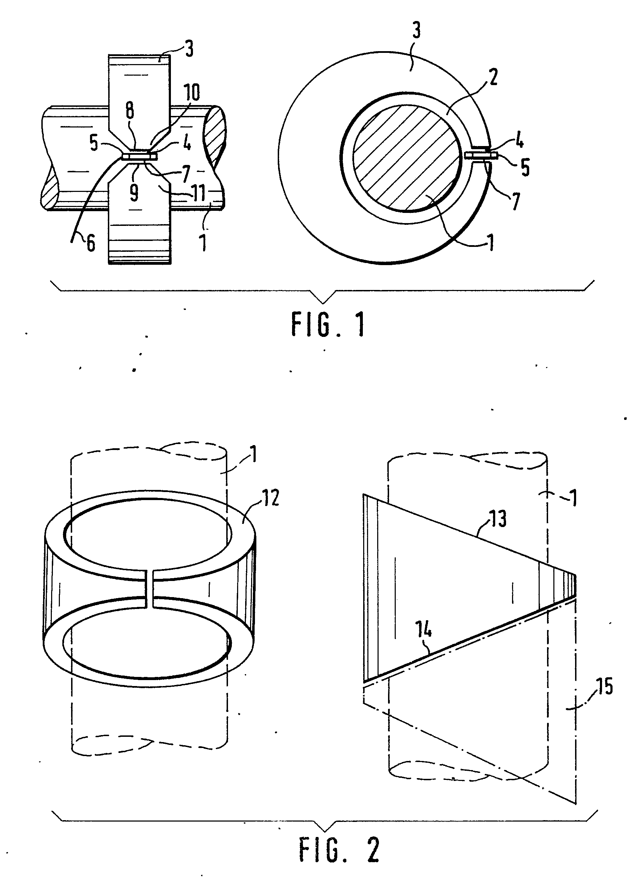

Bei dem in Fig. 1 dargestellten Ausführungsbeispiel ist ein gestrichelt dargestellter Leiter 1 durch eine Öffnung 2 eines Magnetkerns 3 durchgeführt. Der Magnetkern 3 weist einen Spalt 4 auf, in welchem sich ein Magnetfeldsensor 5 befindet, dessen elektrische Anschlüsse 6 lediglich - schematisch dargestellt sind.

Die aktive Fläche 7 des Magnetfeldsensors 5 umfaßt lediglich einen Teil der Gesamtfläche des Magnetfeldsensors 5. Polflächen 8, 9 des Magnetkerns 3 sind bezüglich ihrer Form und Größe an die aktive Fläche 7 des Magnetfeldsensors 5 angepaßt. Die Querschnittsfläche des Magnetkerns 3 wird mit zunehmenden Abstand von den Polflächen 8, 9 größer. Dieses geschieht in dem in Fig. 1 dargestellten Ausführungsbeispiel sowohl durch eine Ausdehnung des Magnetkerns 3 in Längsrichtung des Leiters 1 in den Abschnitten 10, 11 sowie durch eine Ausdehnung des Magnetkerns 3 in radialer Richtung durch die Exzentrizität der Öffnung 2.

Bei dem in Fig. 2 dargestellten Magnetkern 12 erfolgt die Vergrößerung der Querschnittsfläche lediglich in Längsrichtung des Leiters 1. Sie ist jedoch gleichmäßig über den halben Umfang verteilt, so daß die den Magnetkern 12 in Längsrichtung des Leiters begrenzenden Kanten 13, 14 jeweils in einer Ebene liegen. Dadurch kann der in Fig. 2 dargestellte Magnetkern 12 in einfacher Weise aus einem Rohr aus weichmagnetischem Werkstoff hergestellt werden, durch welches in entsprechenden Winkeln Schnitte gelegt werden. Durch Versetzen der einzelnen Werkstücke um 180° kann dieses ohne Verschnitt erfolgen. Ein bei der Herstellung an den Magnetkern 12 angrenzender Magnetkern 15 ist in Fig. 2 strichpunktiert dargestellt.

## Ansprüche

1. Anordnung zur berührungslosen Messung des elektrischen Stroms in einem Leiter, bei welcher ein den Leiter umschließender Magnetkern einen Spalt aufweist, in welchem ein Magnetfeldsensor angeordnet ist, dadurch gekennzeichnet, daß die Polfläche des Magnetkerns (3, 12) im wesentlichen der aktiven Fläche (7) des Magnetfeldsensors (5) entspricht.

2. Anordnung nach Anspruch 1, dadurch gekennzeichnet, daß die Querschnittsfläche des Magnetkerns (3, 12) mit zunehmender Entfernung vom Spalt (4) größer wird.

3. Anordnung nach Anspruch 2, dadurch gekennzeichnet, daß die den Magnetkern (12) in Längsrichtung des Leiters begrenzenden Kanten (13, 14) in je einer Ebene liegen, welche nicht senkrecht zur Achse des durch den Magnetkern (12) gebildeten Kreisrings liegt.

4. Anordnung nach Anspruch 1, dadurch gekennzeichnet, daß der Magnetkern (3, 12) aus amorphem metallischem Glas hoher Permeabilität besteht.

5. Verfahren zur Herstellung einer Anordnung nach Anspruch 3, dadurch gekennzeichnet, daß durch ein Rohr aus weichmagnetischem Werkstoff Schnitte gelegt werden, welche in Ebenen liegen, die abwechselnd in zwei verschiedenen Richtungen Winkel mit der zur Rohrachse senkrechten Ebene bilden, und daß die somit entstehenden Rohrabschnitte an der engsten Stelle geschlitzt werden.

FIG. 1

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE - A - W 12727 VIIIa/21a2 (R. WUNDERLICH)<br>* Seite 2, Zeilen 72-85; Figur 1 *<br><br>--- | 1-2 | G 01 R 15/02<br>G 01 R 33/06 |
| A | DE-B-1 105 514 (SIEMENS-SCHUCKERT AG)<br>* Ansprüche 2, 3; Figur *<br><br>--- | 3 | |
| A | DE-C-3 318 270 (DAIMLER-BENZ AG)<br>* Zusammenfassung; Spalte 4, Zeilen 34-44 *<br><br>----- | 4 | |

RECHERCHIERTE SACHGEBIETE (Int. Cl.4)

G 01 R 15/02
G 01 R 33/06

Der vorliegende Recherchenbericht wurde für alle Patentansprüche erstellt

| Recherchenort | Abschlußdatum der Recherche | Prüfer |
|---|---|---|
| BERLIN | 29-06-1987 | LEMMERICH J |